# EUROPEAN PATENT SPECIFICATION

(11) **EP 4 412 031 B1**
(45) Date of publication and mention of the grant of the patent: **14.10.2026**
(21) Application number: 24152932.0
(22) Date of filing: 19.01.2024
(51) Int. Cl.: H02J 7/00

(54) **FAN CONTROL FOR BATTERY PACK CHARGER**
LÜFTERSTEUERUNG FÜR BATTERIEPACKLADEGERÄT
COMMANDE DE VENTILATEUR POUR CHARGEUR DE BLOC-BATTERIE

(30) Priority: 20.01.2023 US 202363480699 P
(43) Date of publication of application: 07.08.2024
(73) Proprietor: Milwaukee Electric Tool Corporation, Brookfield, WI 53005 (US)
(72) Inventor: SABOURY, Justin, Brookfield, 53045 (US); LEMBERGER, Michael, Wauwatosa, 53226 (US)
(74) Representative: Forresters IP LLP

(56) References cited:
- AU-A1- 2018 290 757
- CN-U- 204 283 948
- JP-A- 2002 063 946
- US-A1- 2007 298 315
- US-A1- 2007 298 316
- US-A1- 2017 331 302

## Description

### RELATED APPLICATIONS

This application claims the benefit of U.S. Provisional Patent Application No. 63/480,699, filed January 20, 2023.

### FIELD

Embodiments described herein provide a battery pack charger. US 2007/298316 A1 refers to an air flow control device that calculates a calorific value of a battery based on an internal resistance of the battery and a charge/discharge current measured by a current measurement unit, calculates the difference as a differential temperature between battery temperature measured by a battery temperature measurement unit and ambient temperature measured by an ambient temperature measurement unit, and controls air flow of the cooling fan on the basis of the calculated calorific value and the differential temperature. US 2007/298315 A1 refers to an air flow control device that calculates a battery temperature change rate indicating an amount of change in battery temperature over a predetermined time based on the battery temperature, and if the calculated battery temperature change rate satisfies a predetermined suppression control condition, the cooling air flow of the cooling fan is suppressed regardless of whether or not the battery temperature is at or below a reference temperature.

### SUMMARY

The invention is defined by the appended claims. Embodiments described herein provide systems and methods for cooling battery pack chargers. The systems and methods include measuring an ambient temperature, measuring or determining a battery pack temperature, and controlling a fan speed based on the ambient temperature and the battery pack temperature. The battery pack charger includes at least one fan and an ambient temperature sensor. The battery pack charger is configured to control operation of the at least one fan. For example, controlling the fan can include turning the fan ON, turning the fan OFF, and varying the fan speed. The battery pack charger controls the at least one fan based on a measurement of ambient temperature received from the ambient temperature sensor and the battery pack temperature. The battery pack charger is also configured to determine or receive a temperature of a battery pack that is being charged. Depending upon whether the ambient temperature is greater than the temperature of the battery pack, the battery pack charger can control the fan differently. By controlling the fan speed, the battery pack charger can maintain the battery pack charger's temperature, allowing for optimal charging time and efficiency.

Battery pack chargers described herein include a battery pack interface configured to receive a battery pack, a fan, an ambient temperature sensor configured to sense an ambient temperature of an environment around the battery pack charger and output a temperature signal, and a controller. The controller is configured to determine the ambient temperature based on the temperature signal, determine a battery pack temperature of the battery pack, and control a speed of the fan based on a comparison of the ambient temperature and the battery pack temperature.

In some aspects, to control the speed of the fan, the controller is configured to increase the speed of the fan based on the comparison of the ambient temperature and the battery pack temperature.

In some aspects, a difference between the ambient temperature and the battery pack temperature is less than a threshold difference value.

In some aspects, to control the speed of the fan, the controller is configured to turn the fan OFF based on the comparison of the ambient temperature and the battery pack temperature.

In some aspects, the battery pack charger further includes a battery pack temperature sensor configured to sense the battery pack temperature associated with the battery pack and output a second temperature signal.

In some aspects, the controller is configured to determine the battery pack temperature based on the second temperature signal.

In some aspects, the battery pack charger further includes a second ambient temperature sensor configured to sense the ambient temperature of the environment around the battery pack charger and output a second temperature signal.

In some aspects, the ambient temperature sensor is located within a housing of the battery pack charger.

In some aspects, the ambient temperature sensor is located at least partially outside of a housing of the battery pack charger.

In some aspects, the battery pack charger further includes a handle that is configured to be movable between a first position and a second position.

In some aspects, in the first position, the handle is configured to lock the battery pack in place on the battery pack charger.

In some aspects, in the first position, the handle obstructs removal of the battery pack from the battery pack charger.

In some aspects, the battery pack charger further includes a second fan.

In some aspects, the battery pack charger further includes a second battery pack interface configured to receive a second battery pack.

Method of controlling a battery pack charger described herein include determining an ambient temperature of an environment around the battery pack charger based on a temperature signal from a temperature sensor, determining a battery pack temperature of a battery pack connected to the battery pack charger, and controlling a speed of a fan based on a comparison of the ambient temperature and the battery pack temperature.

According to the invention, the method further includes comparing, in response to determining that the battery pack temperature is greater than the ambient temperature, the battery pack temperature to a first threshold value, and controlling the fan at a derated speed in response to the battery pack temperature being less than the first threshold value.

According to the invention, the method further includes comparing, in response to determining that the battery pack temperature is not less than the first threshold value, the battery pack temperature to a second threshold value, and controlling the fan to be off in response to the battery pack temperature being less than the second threshold value.

According to the invention, the method further includes comparing, in response to determining that the battery pack temperature is not less than the second threshold value, the battery pack temperature to a third threshold value, and controlling, in response to the battery pack being charged and the battery pack temperature being less than the third threshold value, the fan to be on.

In some aspects, the method further includes controlling, in response to the battery pack temperature being greater than the third threshold value, the fan to be off.

In some aspects, the method further includes comparing, in response to determining that the battery pack temperature is less than the ambient temperature, the battery pack temperature to a first threshold value, and controlling the fan to be off in response to the battery pack temperature being less than the first threshold value.

In some aspects, the method further includes comparing, in response to determining that the battery pack temperature is not less than the first threshold value, the battery pack temperature to a second threshold value, and controlling the fan at a derated speed in response to the battery pack temperature being less than the second threshold value.

In some aspects, the method further includes comparing, in response to determining that the battery pack temperature is not less than the second threshold value, the battery pack temperature to a third threshold value, and controlling, in response to the battery pack temperature being less than the third threshold value, the fan to be on at a maximum fan speed.

In some aspects, the method further includes controlling, in response to the battery pack temperature being greater than the third threshold value, the fan to be on at the maximum fan speed.

Battery pack chargers described herein include a housing, a first fan, a second fan, an ambient temperature sensor, and a controller. The housing includes a battery pack interface. The battery pack interface is configured to receive a battery pack. The first fan is within the housing and is configured to generate airflow through the housing. The second fan is within the housing and is configured to generate airflow through the housing. The ambient temperature sensor is configured to sense an ambient temperature of an environment around the battery pack charger and output a temperature signal. The controller is configured to determine the ambient temperature based on the temperature signal, determine a battery pack temperature of the battery pack, and control a speed of the first fan and the second fan based on a comparison of the ambient temperature and the battery pack temperature.

In some aspects, to control the speed of the fan, the controller is configured to increase the speed of the first fan and the second fan based on the comparison of the ambient temperature and the battery pack temperature.

In some aspects, a difference between the ambient temperature and the battery pack temperature is less than a threshold difference value.

In some aspects, to control the speed of the first fan and the second fan, the controller is configured to turn the first fan and the second fan OFF based on the comparison of the ambient temperature and the battery pack temperature.

In some aspects, the battery pack charger further includes a battery pack temperature sensor configured to sense the battery pack temperature associated with the battery pack and output a second temperature signal.

In some aspects, the controller is configured to determine the battery pack temperature based on the second temperature signal.

In some aspects, the battery pack charger further includes a second ambient temperature sensor configured to sense the ambient temperature of the environment around the battery pack charger and output a second temperature signal.

In some aspects, the controller is further configured to average a first temperature reading based on the temperature signal and a second temperature reading based on the second temperature signal to determine the ambient temperature.

In some aspects, the ambient temperature sensor is located within a housing of the battery pack charger.

In some aspects, the ambient temperature sensor is located at least partially outside of a housing of the battery pack charger.

In some aspects, the battery pack charger further includes a handle that is configured to be movable between a first position and a second position.

In some aspects, in the first position, the handle is configured to lock the battery pack in place on the battery pack charger.

In some aspects, in the first position, the handle obstructs removal of the battery pack from the battery pack charger.

In some aspects, the battery pack charger further includes a second battery pack interface configured to receive a second battery pack.

Before any embodiments are explained in detail, it is to be understood that the embodiments are not limited in application to the details of the configurations and arrangements of components set forth in the following description or illustrated in the accompanying drawings. The embodiments are capable of being practiced or of being carried out in various ways. Also, it is to be understood that the phraseology and terminology used herein are for the purpose of description and should not be regarded as limiting. The use of "including," "comprising," or "having" and variations thereof are meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings.

Unless the context of their usage unambiguously indicates otherwise, the articles "a," "an," and "the" should not be interpreted as meaning "one" or "only one." Rather these articles should be interpreted as meaning "at least one" or "one or more." Likewise, when the terms "the" or "said" are used to refer to a noun previously introduced by the indefinite article "a" or "an," "the" and "said" mean "at least one" or "one or more" unless the usage unambiguously indicates otherwise.

In addition, it should be understood that embodiments may include hardware, software, and electronic components or modules that, for purposes of discussion, may be illustrated and described as if the majority of the components were implemented solely in hardware. However, one of ordinary skill in the art, and based on a reading of this detailed description, would recognize that, in at least one embodiment, the electronic-based aspects may be implemented in software (e.g., stored on non-transitory computer-readable medium) executable by one or more processing units, such as a microprocessor and/or application specific integrated circuits ("ASICs"). As such, it should be noted that a plurality of hardware and software based devices, as well as a plurality of different structural components, may be utilized to implement the embodiments. For example, "servers," "computing devices," "controllers," "processors," etc., described in the specification can include one or more processing units, one or more computer-readable medium modules, one or more input/output interfaces, and various connections (e.g., a system bus) connecting the components.

Relative terminology, such as, for example, "about," "approximately," "substantially," etc., used in connection with a quantity or condition would be understood by those of ordinary skill to be inclusive of the stated value and has the meaning dictated by the context (e.g., the term includes at least the degree of error associated with the measurement accuracy, tolerances [e.g., manufacturing, assembly, use, etc.] associated with the particular value, etc.). Such terminology should also be considered as disclosing the range defined by the absolute values of the two endpoints. For example, the expression "from about 2 to about 4" also discloses the range "from 2 to 4". The relative terminology may refer to plus or minus a percentage (e.g., 1%, 5%, 10%) of an indicated value.

It should be understood that although certain drawings illustrate hardware and software located within particular devices, these depictions are for illustrative purposes only. Functionality described herein as being performed by one component may be performed by multiple components in a distributed manner. Likewise, functionality performed by multiple components may be consolidated and performed by a single component. In some embodiments, the illustrated components may be combined or divided into separate software, firmware and/or hardware. For example, instead of being located within and performed by a single electronic processor, logic and processing may be distributed among multiple electronic processors. Regardless of how they are combined or divided, hardware and software components may be located on the same computing device or may be distributed among different computing devices connected by one or more networks or other suitable communication links. Similarly, a component described as performing particular functionality may also perform additional functionality not described herein. For example, a device or structure that is "configured" in a certain way is configured in at least that way but may also be configured in ways that are not explicitly listed.

Accordingly, in the claims, if an apparatus, method, or system is claimed, for example, as including a controller, control unit, electronic processor, computing device, logic element, module, memory module, communication channel or network, or other element configured in a certain manner, for example, to perform multiple functions, the claim or claim element should be interpreted as meaning one or more of such elements where any one of the one or more elements is configured as claimed, for example, to make any one or more of the recited multiple functions, such that the one or more elements, as a set, perform the multiple functions collectively.

Other aspects of the embodiments will become apparent by consideration of the detailed description and accompanying drawings.

### BRIEF DESCRIPTION OF THE DRAWINGS

FIG. 1 illustrates a side view of a battery pack charger with a battery pack coupled thereto, according to embodiments disclosed herein.
FIG. 2 illustrates an embodiment of the battery pack charger and battery pack of FIG. 1 with the battery pack removed from the battery pack charger, according to embodiments disclosed herein.
FIG. 3A illustrates flow of air into the battery pack charger of FIGS. 1 and 2, according to embodiments disclosed herein.
FIG. 3B illustrates flow of air out of the battery pack charger of FIGS. 1 and 2, according to embodiments disclosed herein.
FIG. 4 illustrates a controller within the battery pack charger of FIGS. 1 and 2, according to embodiments disclosed herein.
FIGS. 5 and 6 illustrate a process for controlling a fan within the battery pack charger of FIGS. 1 and 2, according to embodiments disclosed herein..

### DETAILED DESCRIPTION

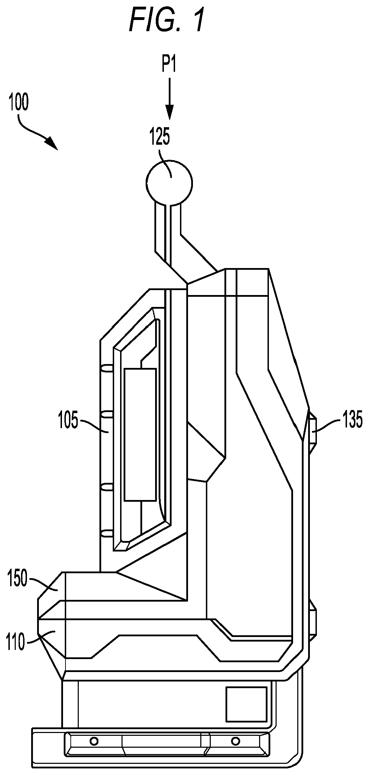

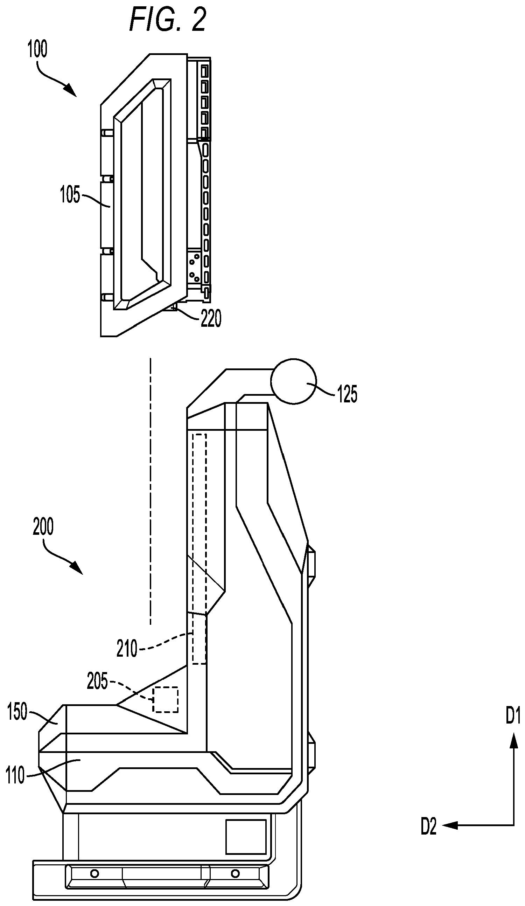

FIG. 1 illustrates an embodiment of a battery pack charger 100. The battery pack charger 100 is illustrated with a rechargeable battery pack 105 removably coupled thereto. The battery pack charger 100 includes a housing 110. The housing 110 includes a connection rail 210 (shown in FIG. 2) extending parallel to a plane P1 or longitudinal battery pack sliding plane. The connection rail 210 allows the rechargeable battery pack 105 to slidably couple to the battery pack charger 100 in a direction extending parallel to the plane P1, such as along a longitudinal battery sliding axis.

The battery pack charger 100 further includes charging terminals 205 (shown in FIG. 2) configured to electrically couple with corresponding battery terminals of rechargeable battery pack 105. Upon sliding the rechargeable battery pack 105 along the connection rail 210, the battery terminals of the rechargeable battery pack 105 contact the charging terminals 205 of the battery pack charger 100 when the rechargeable battery pack 105 is in an installed position. The rechargeable battery pack 105 is moved from a position remote from the battery pack charger 100 (as shown in FIG. 2) to the installed position (as shown in FIG. 1) by first entering a battery pack entry end 220 of a battery pack receiving area 200. The battery pack charger 100 includes an ambient temperature sensor 150. The ambient temperature sensor 150 measures an ambient temperature of an environment around or associated with the battery pack charger 100. In some embodiments, the ambient temperature sensor 150 is located within the housing 110 of the battery pack charger 100. In other embodiments, the ambient temperature sensor 150 is located fully or at least partially outside of the housing 110 of the battery pack charger 100.

As shown in FIG. 2, the battery pack receiving area 200 is defined by the housing 110. In the illustrated embodiment, the battery pack receiving area 200 is bordered on one side by the connection rail 210. Also in the illustrated embodiment, the battery pack receiving area 200 is open in two perpendicular directions D1, D2 away from the housing 110. In some embodiments, the charging terminals 205 are disposed in the battery pack receiving area 200 opposite the battery pack entry end 220 of the rechargeable battery pack 105.

A handle 125 of the battery pack charger 100 is movable between at least a first position and a second position. In the first position (as shown in FIG. 1), while the rechargeable battery pack 105 is in the installed position, the handle 125 locks the rechargeable battery pack 105 in place on the battery pack charger 100 or otherwise obstructs or blocks removal of the rechargeable battery pack 105 from the battery pack charger 100. In some embodiments, in the first position, at least a portion of the handle 125 intersects with the plane P1 along which the connection rail 210 extends. In some embodiments, in the first position, at least a portion of the handle 125 obstructs at least a portion of the battery pack entry end 220 in a direction D1 that is parallel to the plane P1.

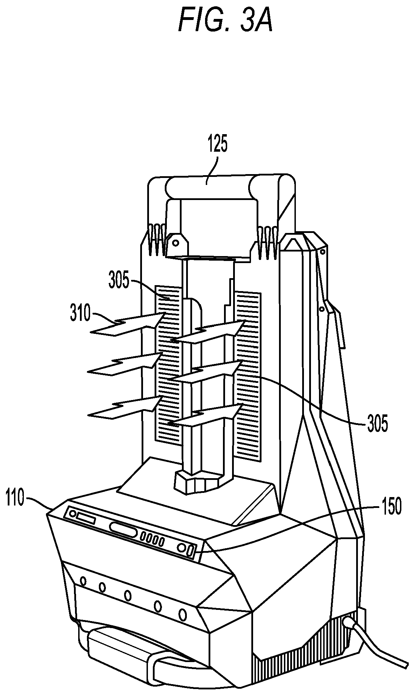

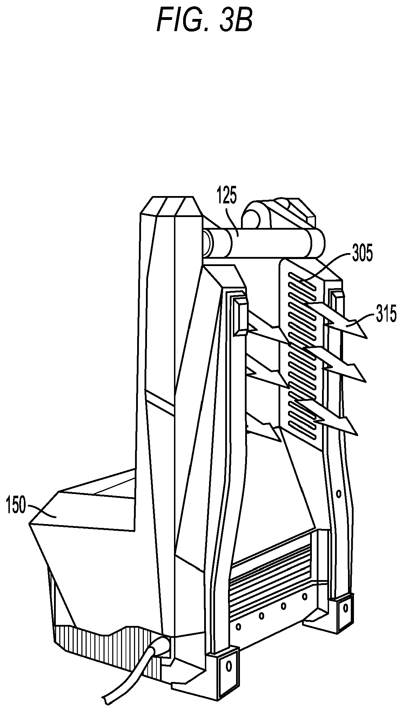

FIG. 3A illustrates airflow into the battery pack charger 100. The battery pack charger 100 receives an input airflow 310 into battery pack charger fan(s) 305 within the housing 110 (e.g., through air vents in the housing 110). The temperature of the input airflow 310 is measured by the ambient temperature sensor 150. In FIG. 3A, the battery pack charger 100 does not have a rechargeable battery pack 105 coupled to the battery pack charger 100. FIG. 3B illustrates an output airflow 315 after the input airflow 310 has passed through the fan(s) 305, consequently cooling the battery pack charger 100. In some embodiments, the fan(s) 305 are controlled to cool the battery pack charger 100 based on both the measured ambient temperature and the measured battery pack temperature.

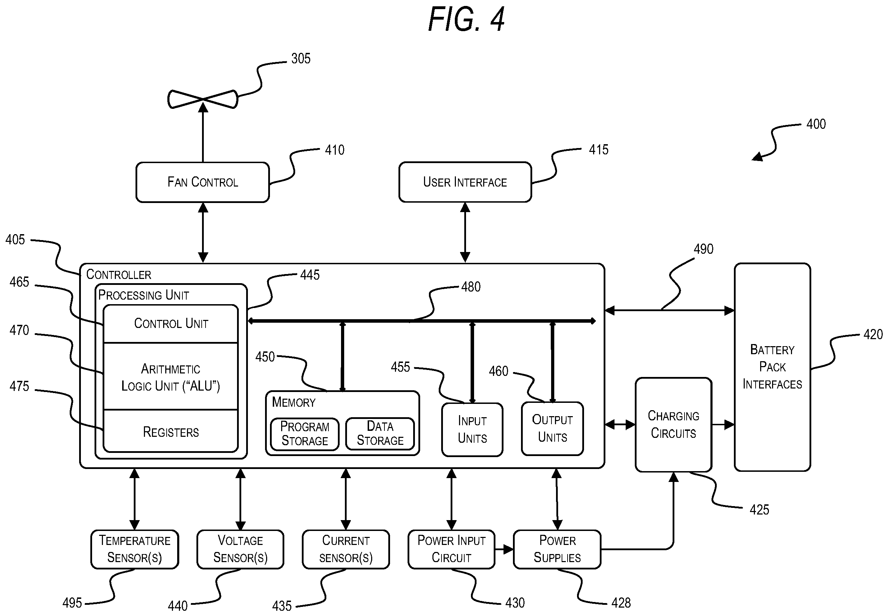

FIG. 4 illustrates a control system 400 for the battery pack charger 100. The control system 400 includes a controller 405. The controller 405 is electrically and/or communicatively connected to a variety of modules or components of the battery pack charger 100. For example, the illustrated controller 405 is electrically connected to a fan control 410, a user interface 415, one or more battery pack interfaces 420, charging circuits 425, power supplies 428, a power input circuit 430, one or more current sensors 435, one or more voltage sensors 440, and one or more temperature sensors 495. The controller 405 includes combinations of hardware and software that are operable to, among other things, control the operation of the battery pack charger 100. The fan control 410 operates the one or more fans 305. In some embodiments, the user interface 415 includes a touchscreen. In some embodiments, the user interface 415 includes various components (e.g., switches, buttons, levers, dials, etc.) that allow a user to interface with and control the battery pack charger 100.

The controller 405 includes a plurality of electrical and electronic components that provide power, operational control, and protection to the components and modules within the controller 405 and/or battery pack charger 100. For example, the controller 405 includes, among other things, a processing unit 445 (e.g., a microprocessor, a microcontroller, an electronic controller, an electronic processor, or another suitable programmable device), a memory 450, input units 455, and output units 460. The processing unit 445 includes, among other things, a control unit 465, an arithmetic logic unit ("ALU") 470, and a plurality of registers 475 (shown as a group of registers in FIG. 4), and is implemented using a known computer architecture (e.g., a modified Harvard architecture, a von Neumann architecture, etc.). The processing unit 445, the memory 450, the input units 455, and the output units 460, as well as the various modules or circuits connected to the controller 405 are connected by one or more control and/or data buses (e.g., common bus 480). The control and/or data buses are shown generally in FIG. 4 for illustrative purposes. The use of one or more control and/or data buses for the interconnection between and communication among the various modules, circuits, and components would be known to a person skilled in the art in view of the embodiments described herein.

The memory 450 is a non-transitory computer readable medium and includes, for example, a program storage area and a data storage area. The program storage area and the data storage area can include combinations of different types of memory, such as a ROM, a RAM (e.g., DRAM, SDRAM, etc.), EEPROM, flash memory, a hard disk, an SD card, or other suitable magnetic, optical, physical, or electronic memory devices. The processing unit 445 is connected to the memory 450 and executes software instructions that are capable of being stored in a RAM of the memory 450 (e.g., during execution), a ROM of the memory 450 (e.g., on a generally permanent basis), or another non-transitory computer readable medium such as another memory or a disc. Software included in the implementation of the battery pack charger 100 can be stored in the memory 450 of the controller 405. The software includes, for example, firmware, one or more applications, program data, filters, rules, one or more program modules, and other executable instructions. The controller 405 is configured to retrieve from the memory 450 and execute, among other things, instructions related to the control processes and methods described herein. In other constructions, the controller 405 includes additional, fewer, or different components.

The one or more battery pack interfaces 420 include a combination of mechanical components (e.g., rails, grooves, latches, etc.) and electrical components (e.g., one or more terminals) configured to and operable for interfacing (e.g., mechanically, electrically, and communicatively connecting) the battery pack charger 100 with a battery pack (e.g., rechargeable battery pack 105). For example, the battery pack interfaces 420 are configured to receive power through the charging circuits 425 via the power input circuit 430 and power supplies 428. The battery pack interfaces 420 are also configured to communicatively connect to the controller 405 via one or more communications lines 490.

In some embodiments, the controller 405 is configured to control the transfer of power to the charging circuits 425 based on detected power conditions in the battery pack charger 100. For example, the current sensors 435 and the voltage sensors 440 communicate to the controller 405 the amount of current and voltage available in the battery pack charger 100, respectively. The individual charging circuits 425 can communicate, to the controller 405, the amount of power needed by the rechargeable battery pack 105 as well as the power rating of the rechargeable battery pack 105 that is electrically connected to the respective charging circuits 425.

The controller 405 is configured to control switches coupled to power supplies 428 to output a requested power from at least one charging circuit 425 to the battery pack(s) 105. In some embodiments, the controller 405 controls the switches based on an input received at the user interface 415. For example, when the battery pack charger 100 includes two charging ports (e.g., for charging two rechargeable battery packs 105), a user may wish to use a high-power configuration that charges a first battery pack at a first interface using multiple power supplies 428. In other words, the first battery pack can receive power from a first power supply and a second power supply to be charged according to a high-power configuration. As another example, a user may wish to use a low-power configuration that charges both the first battery pack and the second battery pack using the first power supply and the second power supply, respectively. The high-power configuration fully charges the first battery pack at a faster rate than the low-power configuration.

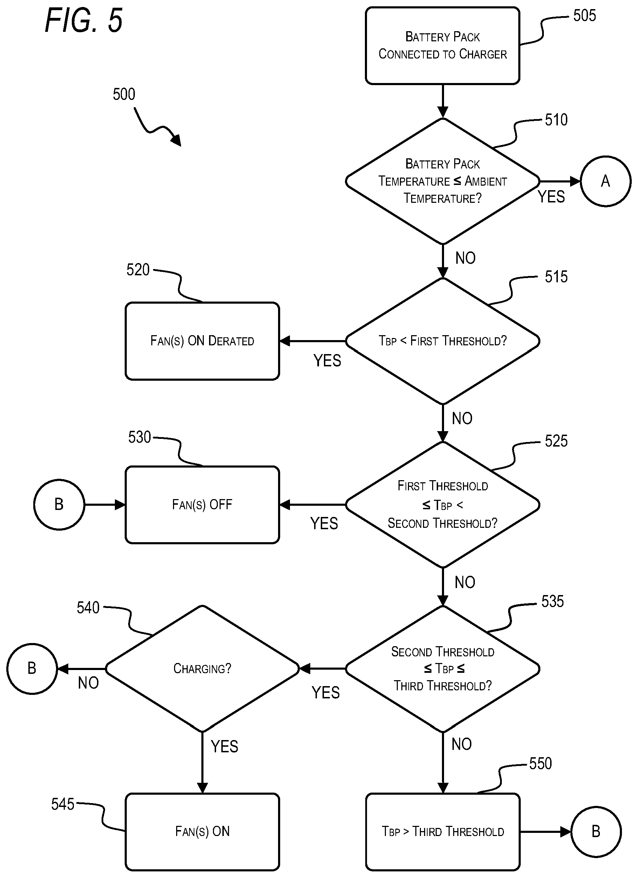

FIG. 5 illustrates a process 500 for controlling the one or more fans 305 of the battery pack charger 100. The rechargeable battery pack 105 is first connected to the battery pack charger 100 (STEP 505) to be recharged. The controller 405 receives signal or a measurement from the ambient temperature sensor 150 and determines a temperature of the rechargeable battery pack 105. In some embodiments, the controller 405 receives a signal or a measurement from a battery pack temperature sensor within the battery pack charger 100. In other embodiments, the battery pack charger 100 receives the temperature of the rechargeable battery pack 105 from the rechargeable battery pack 105 (e.g., over communication line 490).

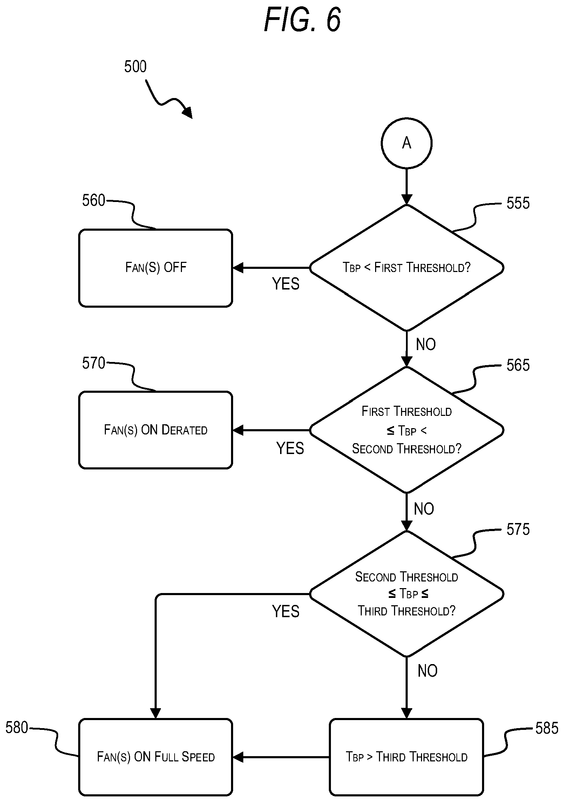

The controller 405 compares the ambient temperature measurement and the battery pack temperature (STEP 510). If the battery pack temperature is less than or equal to the ambient temperature, the process 500 proceeds to control STEP 555 shown in and described with respect to FIG. 6. If the ambient temperature is greater than the battery pack temperature, the controller compares the battery pack temperature to a first threshold (STEP 515). If the battery pack temperature is less than the first threshold, the fan(s) 305 are ON, and the speed of the fan(s) 305 is derated (STEP 520). In some embodiments, the speed of the fan(s) 305 is derated (e.g., reduced) based on a difference between the ambient temperature and the battery pack temperature. For example, if the difference between the ambient temperature and the battery pack temperature is a smaller value (for example, around 2°C), the speed of the fan(s) 305 is set to a higher value (but less than full speed). When the difference between the ambient temperature and the battery pack temperature is a larger value, the speed of the fan(s) 305 is set to a lower value (but the fan(s) 305 are not turned OFF).

If the battery pack temperature is greater than or equal to the first threshold, the battery pack temperature is then compared to a second threshold (STEP 525). If the battery pack temperature is greater than or equal to a first threshold and less than the second threshold, the fan(s) 305 are turned OFF or remain OFF (STEP 530). If the battery pack temperature is greater than or equal to the second threshold, the battery pack temperature is then compared to a third threshold (STEP 535). If the battery pack temperature is greater than or equal to the second threshold and less than or equal to the third threshold, the controller 405 determines whether the rechargeable battery pack 105 is currently being charged (STEP 540). If the battery pack is currently being charged, the fan(s) 305 are turned ON or remain ON (STEP 545). If the battery pack is not currently being charged, the fan(s) 305 are turned OFF or remain OFF (STEP 530). If, at STEP 535, the battery pack temperature is greater than the third threshold (STEP 550), the fan(s) 305 are turned OFF or remain OFF (STEP 530). In some embodiments, when the battery pack temperature is greater than the third threshold, the battery pack charger 100 implements a temperature sensor failure mitigation operation. For example, the battery pack charger 100 can be configured to turn the fan(s) 305 ON. In some embodiments, the battery pack charger includes a second or redundant ambient temperature sensor 150 that can be used in the event the first ambient temperature sensor 150 fails. In some embodiments, the battery pack charger can average measurements from each of a plurality of ambient temperature sensors 150. For example, the ambient temperature sensors 150 can be placed at different locations on the battery pack charger can cancel out effects heat sources, such as charging electronics and the rechargeable battery pack 105. In some embodiments, the determined ambient temperature around the battery pack charger 100 is within (i.e., +/-) 5°C of an actual outside ambient air temperature.

With reference to FIG. 6, if the battery pack temperature is greater than the ambient temperature, the battery pack temperature is compared to a first threshold (STEP 555). If the battery pack temperature is less than the first threshold, the fan(s) 305 are turned OFF or remain OFF (STEP 560). If the battery back temperature is greater than or equal to the first threshold, the battery pack temperature is compared to a second threshold (STEP 565). If the battery pack temperature is greater than or equal to the first threshold and less than the second threshold, the fan(s) 305 are turned ON or remain ON, but the speed of the fan is derated (STEP 570). In some embodiments, the speed of the fan(s) 305 is derated (e.g., reduced) based on a difference between the ambient temperature and the battery pack temperature. For example, if the difference between the ambient temperature and the battery pack temperature is a smaller value (for example, around 2°C), the speed of the fan(s) 305 is set to a higher value (but less than full speed). When the difference between the ambient temperature and the battery pack temperature is a larger value, the speed of the fan(s) 305 is set to a lower value (but the fan(s) 305 are not turned OFF). If, at STEP 565, the battery pack temperature is greater than the second threshold, the battery pack temperature is compared to a third threshold (STEP 575). If the battery pack temperature is greater than or equal to the second threshold and less than or equal to the third threshold, the fan(s) 305 are turned ON or remain ON at a maximum or full speed (STEP 580). If, at STEP 575, the battery back temperature is not between or equal to the second threshold and the third threshold, the battery pack temperature is greater than the third threshold (STEP 585). If the battery pack temperature is greater than the third threshold, the fan(s) 305 are turned ON or remain ON at the maximum or full speed (STEP 580). Comparing the ambient temperature and the battery pack temperature to one another, and comparing battery pack temperature to a plurality of thresholds allows the battery pack charger 100 to control the fan(s) 305 to most effectively cool the battery pack charger 100 and charge the rechargeable battery pack 105.

Thus, embodiments described herein provide, among other things, systems and methods for battery pack charger fan control based on ambient temperature and battery pack temperature.

## Claims

1. A battery pack charger (100) comprising:
a battery pack interface configured to receive a battery pack (105);
a fan (305);
an ambient temperature sensor (150) configured to sense an ambient temperature of an environment around the battery pack charger and output a temperature signal; and
a controller (405) configured to:
determine the ambient temperature based on the temperature signal,
determine a battery pack temperature of the battery pack, and
control a speed of the fan (305) based on a comparison of the ambient temperature and the battery pack temperature;
compare, in response to determining that the battery pack temperature is greater than the ambient temperature, the battery pack temperature to a first threshold value;
control the fan (305) at a derated speed in response to the battery pack temperature being less than the first threshold value;
compare, in response to determining that the battery pack temperature is not less than the first threshold value, the battery pack temperature to a second threshold value;
control the fan (305) to be off in response to the battery pack temperature being less than the second threshold value;
compare, in response to determining that the battery pack temperature is not less than the second threshold value, the battery pack temperature to a third threshold value; and
control, in response to the battery pack being charged and the battery pack temperature being less than the third threshold value, the fan (305) to be on.

2. The battery pack charger of claim 1, wherein, to control the speed of the fan (305), the controller (405) is configured to increase the speed of the fan (305) based on the comparison of the ambient temperature and the battery pack temperature.

3. The battery pack charger of claim 2, wherein a difference between the ambient temperature and the battery pack temperature is less than a threshold difference value.

4. The battery pack charger of claim 1, wherein the controller (405) is further configured to control, in response to the battery pack not being charged and the battery pack temperature being less than the third threshold value, the fan to be OFF.

5. The battery pack charger of claim 1, further comprising:
a battery pack temperature sensor configured to sense the battery pack temperature associated with the battery pack and output a temperature signal for the battery pack temperature; and optionally,
wherein the controller (405) is configured to determine the battery pack temperature based on the temperature signal for the battery pack temperature.

6. The battery pack charger of claim 1, further comprising:
a second ambient temperature sensor configured to sense the ambient temperature of the environment around the battery pack charger and output a second temperature signal for the ambient temperature of the environment around the battery pack charger.

7. The battery pack charger of claim 1, wherein the ambient temperature sensor is located within a housing (110) of the battery pack charger; or optionally,
wherein the ambient temperature sensor is located at least partially outside of the housing (110) of the battery pack charger.

8. A method of controlling a battery pack charger (100), the method comprising:
determining an ambient temperature of an environment around the battery pack charger based on a temperature signal from a temperature sensor (150);
determining a battery pack temperature of a battery pack (105) connected to the battery pack charger;
controlling a speed of a fan (305) based on a comparison of the ambient temperature and the battery pack temperature;
comparing, in response to determining that the battery pack temperature is greater than the ambient temperature, the battery pack temperature to a first threshold value;
controlling the fan (305) at a derated speed in response to the battery pack temperature being less than the first threshold value;
comparing, in response to determining that the battery pack temperature is not less than the first threshold value, the battery pack temperature to a second threshold value;
controlling the fan (305) to be off in response to the battery pack temperature being less than the second threshold value;
comparing, in response to determining that the battery pack temperature is not less than the second threshold value, the battery pack temperature to a third threshold value; and
controlling, in response to the battery pack being charged and the battery pack temperature being less than the third threshold value, the fan (305) to be on.

9. The method of claim 8, further comprising:
controlling, in response to the battery pack not being charged and the battery pack temperature being less than the third threshold value, the fan (305) to be OFF.

10. The method of claim 8, further comprising:
controlling, in response to the battery pack temperature being greater than the third threshold value, the fan (305) to be off.

11. The method of claim 8, further comprising:
comparing, in response to determining that the battery pack temperature is less than the ambient temperature, the battery pack temperature to a first threshold value; and
controlling the fan (305) to be off in response to the battery pack temperature being less than the first threshold value.

12. The method of claim 11, further comprising:
comparing, in response to determining that the battery pack temperature is not less than the first threshold value, the battery pack temperature to a second threshold value; and
controlling the fan (305) at a derated speed in response to the battery pack temperature being less than the second threshold value.

13. The method of claim 12, further comprising:
comparing, in response to determining that the battery pack temperature is not less than the second threshold value, the battery pack temperature to a third threshold value; and
controlling, in response to the battery pack temperature being less than the third threshold value, the fan (305) to be on at a maximum fan speed; and optionally,
controlling, in response to the battery pack temperature being greater than the third threshold value, the fan (305) to be on at the maximum fan speed.

## Patentansprüche

1. Batteriepackladegerät (100), umfassend:
Eine Batteriepackschnittstelle, die dazu konfiguriert ist, einen Batteriepack (105) aufzunehmen;
einen Lüfter (305);
einen Umgebungstemperatursensor (150), der dazu konfiguriert ist, eine Umgebungstemperatur einer Umgebung, um das Batteriepackladegerät herum zu erfassen und ein Temperatursignal auszugeben; und
eine Steuereinheit (405), die konfiguriert ist, Folgendes zu tun:
Bestimmen der Umgebungstemperatur anhand des Temperatursignals,
Bestimmen einer Batteriepacktemperatur, und
Steuern der Drehzahl des Lüfters (305) anhand eines Vergleichs der Umgebungstemperatur und der Batteriepacktemperatur;
Vergleichen, als Reaktion auf die Feststellung, dass die Batteriepacktemperatur höher als die Umgebungstemperatur ist, der Batteriepacktemperatur mit einem ersten Schwellenwert;
Steuern des Lüfters (305) mit reduzierter Drehzahl, als Reaktion darauf, dass die Batteriepacktemperatur weniger als der erste Schwellenwert ist;
Vergleichen, als Reaktion auf die Feststellung, dass die Batteriepacktemperatur nicht weniger als der erste Schwellenwert ist, der Batteriepacktemperatur mit einem zweiten Schwellenwert;
den Lüfter (305) so ansteuern, dass er ausgeschaltet ist, wenn die Batteriepacktemperatur weniger als der zweite Schwellenwert ist;
Vergleichen, als Reaktion auf die Feststellung, dass die Batteriepacktemperatur nicht weniger als der zweite Schwellenwert ist, der Batteriepacktemperatur mit einem dritten Schwellenwert; und
Steuern des Lüfters (305) in einen eingeschalteten Zustand als Reaktion darauf, dass der Batteriepack geladen wird und die Batteriepacktemperatur weniger als der dritte Schwellenwert ist.

2. Batteriepackladegerät nach Anspruch 1, wobei die Steuereinheit (405) dazu konfiguriert ist, zur Regelung der Drehzahl des Lüfters (305) die Drehzahl des Lüfters (305) auf der Grundlage des Vergleichs der Umgebungstemperatur und der Batteriepacktemperatur zu erhöhen.

3. Batteriepackladegerät nach Anspruch 2, wobei eine Differenz zwischen der Umgebungstemperatur und der Batteriepacktemperatur weniger als ein Differenzwert für den Schwellenwert ist.

4. Batteriepackladegerät nach Anspruch 1, wobei die Steuereinheit (405) ferner dazu konfiguriert ist, als Reaktion darauf, dass der Batteriepack nicht geladen wird und die Batteriepacktemperatur weniger als der dritte Schwellenwert ist, den Lüfter so zu steuern, dass er in den Zustand "AUS" geschaltet wird.

5. Batteriepackladegerät nach Anspruch 1, ferner umfassend:
Einen Batteriepacktemperatursensor, der so konfiguriert ist, dass er die dem Batteriepack zugeordnete Batteriepacktemperatur erfasst und ein Temperatursignal für die Batteriepacktemperatur ausgibt; und optional
wobei die Steuereinheit (405) dazu konfiguriert ist, die Batteriepacktemperatur auf der Grundlage des Temperatursignals für die Batteriepacktemperatur zu bestimmen.

6. Batteriepackladegerät nach Anspruch 1, ferner umfassend:
Einen zweiten Umgebungstemperatursensor, der dazu konfiguriert ist, die Umgebungstemperatur der Umgebung um das Batterieladegerät herum zu erfassen und ein zweites Temperatursignal für die Umgebungstemperatur der Umgebung um das Batterieladegerät herum auszugeben.

7. Batteriepackladegerät nach Anspruch 1, wobei der Umgebungstemperatursensor in einem Gehäuse (110) des Batteriepackladegeräts angeordnet ist; oder optional,
wobei sich der Umgebungstemperatursensor zumindest teilweise außerhalb des Gehäuses (110) des Batteriepackladegeräts befindet.

8. Verfahren zur Steuerung eines Batteriepackladegeräts (100), wobei das Verfahren umfasst:
Bestimmen einer Umgebungstemperatur einer Umgebung um das Batteriepackladegerät auf der Grundlage eines Temperatursignals eines Temperatursensors (150);
Bestimmen einer Batteriepacktemperatur eines mit dem Batteriepackladegerät verbundenen Batteriepacks (105);
Steuern einer Drehzahl des Lüfters (305) anhand eines Vergleichs der Umgebungstemperatur und der Batteriepacktemperatur;
Vergleichen, als Reaktion auf die Feststellung, dass die Batteriepacktemperatur höher als die Umgebungstemperatur ist, der Batteriepacktemperatur mit einem ersten Schwellenwert;
Steuern des Lüfters (305) mit reduzierter Drehzahl als Reaktion darauf, dass die Batteriepacktemperatur weniger als der erste Schwellenwert ist;
Vergleichen, als Reaktion auf die Feststellung, dass die Batteriepacktemperatur nicht weniger als der erste Schwellenwert ist, der Batteriepacktemperatur mit einem zweiten Schwellenwert;
den Lüfter (305) so ansteuern, dass er ausgeschaltet ist, wenn die Batteriepacktemperatur weniger als der zweite Schwellenwert ist;
Vergleichen, als Reaktion auf die Feststellung, dass die Batteriepacktemperatur nicht weniger als der zweite Schwellenwert ist, der Batteriepacktemperatur mit einem dritten Schwellenwert; und
Steuern des Lüfters (305) in einen eingeschalteten Zustand als Reaktion darauf, dass der Batteriepack geladen wird und die Batteriepacktemperatur weniger als der dritte Schwellenwert ist.

9. Verfahren nach Anspruch 8, ferner umfassend:
Steuern des Lüfters (305) in den Zustand "AUS" als Reaktion darauf, dass der Batteriepack nicht geladen wird und die Batteriepacktemperatur weniger als der dritte Schwellenwert ist.

10. Verfahren nach Anspruch 8, ferner umfassend:
Steuern des Lüfters (305) in den ausgeschalteten Zustand als Reaktion darauf, dass die Batteriepacktemperatur höher als der dritte Schwellenwert ist.

11. Verfahren nach Anspruch 8, ferner umfassend:
Vergleichen, als Reaktion auf die Feststellung, dass die Batteriepacktemperatur weniger als die Umgebungstemperatur ist, der Batteriepacktemperatur mit einem ersten Schwellenwert; und
den Lüfter (305) so ansteuern, dass er ausgeschaltet ist, wenn die Batteriepacktemperatur weniger als der erste Schwellenwert ist.

12. Verfahren nach Anspruch 11, ferner umfassend:
Vergleichen, als Reaktion auf die Feststellung, dass die Batteriepacktemperatur nicht weniger als der erste Schwellenwert ist, der Batteriepacktemperatur mit einem zweiten Schwellenwert; und
Steuern des Lüfters (305) mit einer reduzierten Drehzahl als Reaktion darauf, dass die Batteriepacktemperatur weniger als der zweite Schwellenwert ist;

13. Verfahren nach Anspruch 12, ferner umfassend:
Vergleichen, als Reaktion auf die Feststellung, dass die Batteriepacktemperatur nicht weniger als der zweite Schwellenwert ist, der Batteriepacktemperatur mit einem dritten Schwellenwert; und
Steuern, als Reaktion darauf, dass die Batteriepacktemperatur weniger als der dritte Schwellenwert ist, des Lüfters (305) mit einer maximalen Drehzahl des Lüfters; und optional,
Steuern, als Reaktion darauf, dass die Batteriepacktemperatur höher als der dritte Schwellenwert ist, des Lüfters (305) mit der maximalen Drehzahl des Lüfters.

## Revendications

1. Un chargeur de bloc-batterie (100) comprenant :
une interface de bloc-batterie configurée pour recevoir un bloc-batterie (105) ;
un ventilateur (305) ;
un capteur de température ambiante (150) configuré pour capter une température ambiante d'un environnement autour du chargeur de bloc-batterie et émettre un signal de température ; et
un contrôleur (405) configuré pour :
déterminer la température ambiante à partir du signal de température,
déterminer une température de bloc-batterie du bloc-batterie, et
contrôler une vitesse du ventilateur (305) sur la base d'une comparaison de la température ambiante et la température du bloc-batterie ;
comparer, en réponse à la constatation que la température du bloc-batterie est plus élevée que la température ambiante, la température du bloc-batterie et une première valeur-seuil ;
réduire la vitesse du ventilateur (305) en réponse au fait que la température du bloc-batterie est inférieure à la première valeur-seuil ;
comparer, en réponse à la constatation que la température du bloc-batterie n'est pas inférieure à la première valeur-seuil, la température du bloc-batterie et une deuxième valeur-seuil ;
arrêter le ventilateur (305) en réponse au fait que la température du bloc-batterie est inférieure à la deuxième valeur-seuil ;
comparer, en réponse à la constatation que la température du bloc-batterie n'est pas inférieure à la deuxième valeur-seuil, la température du bloc-batterie et une troisième valeur-seuil ; et
mettre le ventilateur (305) en marche, en réponse au fait que le bloc-batterie est en cours de charge et la température du bloc-batterie est inférieure à la troisième valeur-seuil.

2. Le chargeur de bloc-batterie de la revendication 1, dans lequel, pour contrôler la vitesse du ventilateur (305), le contrôleur (405) est configuré pour augmenter la vitesse du ventilateur (305) sur la base de la comparaison de la température ambiante et la température du bloc-batterie.

3. Le chargeur de bloc-batterie de la revendication 2, dans lequel une différence entre la température ambiante et la température du bloc-batterie est inférieure à une valeur de différence seuil.

4. Le chargeur de bloc-batterie de la revendication 1, dans lequel le contrôleur (405) est de plus configuré pour arrêter le ventilateur en réponse au fait que le bloc-batterie n'est pas en cours de charge et la température du bloc-batterie est inférieure à la troisième valeur-seuil.

5. Le chargeur de bloc-batterie de la revendication 1, comprenant en sus :
un capteur de température de bloc-batterie configuré pour capter la température de bloc-batterie associée au bloc-batterie et émettre un signal de température pour la température du bloc-batterie ; et éventuellement
dans lequel le contrôleur (405) est configuré pour déterminer la température du bloc-batterie à partir du signal de température pour la température du bloc-batterie.

6. Le chargeur de bloc-batterie de la revendication 1, comprenant en sus :
un deuxième capteur de température ambiante configuré pour capter la température ambiante de l'environnement autour du chargeur de bloc-batterie et émettre un deuxième signal de température pour la température ambiante de l'environnement autour du chargeur de bloc-batterie.

7. Le chargeur de bloc-batterie de la revendication 1, dans lequel le capteur de température ambiante est situé à l'intérieur d'un boîtier (110) du chargeur de bloc-batterie ; ou éventuellement
dans lequel le capteur de température ambiante est situé au moins partiellement à l'extérieur du boîtier (110) du chargeur de bloc-batterie.

8. Un procédé de contrôle d'un chargeur de bloc-batterie (100), le procédé comprenant :
déterminer une température ambiante d'un environnement autour du chargeur de bloc-batterie à partir d'un signal de température émis par un capteur de température (150) ;
déterminer une température de bloc-batterie d'un bloc-batterie (105) connecté au chargeur de bloc-batterie ;
contrôler une vitesse d'un ventilateur (305) sur la base d'une comparaison de la température ambiante et la température du bloc-batterie ;
comparer, en réponse à la constatation que la température du bloc-batterie est supérieure à la température ambiante, la température du bloc-batterie et une première valeur-seuil ;
réduire la vitesse du ventilateur (305) en réponse au fait que la température du bloc-batterie est inférieure à la première valeur-seuil ;
comparer, en réponse à la constatation que la température du bloc-batterie n'est pas inférieure à la première valeur-seuil, la température du bloc-batterie et une deuxième valeur-seuil ;
arrêter le ventilateur (305) en réponse au fait que la température du bloc-batterie est inférieure à la deuxième valeur-seuil ;
comparer, en réponse à la constatation que la température du bloc-batterie n'est pas inférieure à la deuxième valeur-seuil, la température du bloc-batterie et une troisième valeur-seuil ; et
mettre le ventilateur (305) en marche, en réponse au fait que le bloc-batterie est en cours de charge et la température du bloc-batterie est inférieure à la troisième valeur-seuil.

9. Le procédé de la revendication 8, comprenant en sus :
arrêter le ventilateur (305) en réponse au fait que le bloc-batterie n'est pas en cours de charge et la température du bloc-batterie est inférieure à la troisième valeur-seuil.

10. Le procédé de la revendication 8, comprenant en sus :
arrêter le ventilateur (305) en réponse au fait que la température du bloc-batterie est supérieure à la troisième valeur-seuil.

11. Le procédé de la revendication 8, comprenant en sus :
comparer, en réponse à la constatation que la température du bloc-batterie est inférieure à la température ambiante, la température du bloc-batterie et une première valeur-seuil ; et
arrêter le ventilateur (305) en réponse au fait que la température du bloc-batterie est inférieure à la première valeur-seuil.

12. Le procédé de la revendication 11, comprenant en sus :
comparer, en réponse à la constatation que la température du bloc-batterie n'est pas inférieure à la première valeur-seuil, la température du bloc-batterie et une deuxième valeur-seuil ; et
réduire la vitesse du ventilateur (305) en réponse au fait que la température du bloc-batterie est inférieure à la deuxième valeur-seuil.

13. Le procédé de la revendication 12, comprenant en sus :
comparer, en réponse à la constatation que la température du bloc-batterie n'est pas inférieure à la deuxième valeur-seuil, la température du bloc-batterie et une troisième valeur-seuil ; et
augmenter la vitesse du ventilateur (305) jusqu'à une vitesse maximum de ventilateur en réponse au fait que la température du bloc-batterie est inférieure à la troisième valeur-seuil ; et éventuellement,
augmenter la vitesse du ventilateur (305) jusqu'à une vitesse maximum de ventilateur en réponse au fait que la température du bloc-batterie est supérieure à la troisième valeur-seuil.
